Europäisches Patentamt

European Patent Office

Office européen des brevets

(11) Publication number: **0 060 257**
**B1**

(12) EUROPEAN PATENT SPECIFICATION

(45) Date of publication of patent specification: 02.10.85

(21) Application number: 81902068.6

(22) Date of filing: 02.06.81

(86) International application number:
PCT/US81/00733

(87) International publication number:
WO 82/01016 01.04.82 Gazette 82/09

(51) Int. Cl.⁴: **C 21 D 1/00, C 21 D 1/09,**
**C 21 D 9/30**

(54) METHOD FOR SURFACE HARDENING CAMS.

(30) Priority: 11.09.80 US 186393

(43) Date of publication of application:
22.09.82 Bulletin 82/38

(45) Publication of the grant of the patent:
02.10.85 Bulletin 85/40

(84) Designated Contracting States:
DE FR GB SE

(56) References cited:
EP-A-0 001 889
FR-A-2 444 082
GB-A-2 004 613
GB-A-2 022 146
US-A-2 017 305
US-A-2 800 809
US-A-3 090 712
US-A-3 210 518
US-A-3 411 380
US-A-3 615 905
US-A-3 650 846
US-A-3 944 446
US-A-4 043 847

(73) Proprietor: SCIAKY BROS., INC.
4915 West 67th Street
Chicago Illinois 60638 (US)

(72) Inventor: SCIAKY, Albert M.
11750 South 85th Avenue
Palos Park, IL 60464 (US)
Inventor: FARRELL, William J.
2908 MacFarlane Crescent
Flossmoor, IL 60422 (US)
Inventor: REYNOLDS, Richard W.
17306 Bryant Lane
Hazel Crest, IL 60429 (US)

(74) Representative: Hartley, David et al
c/o Withers & Rogers 4 Dyer's Buildings Holborn
London, EC1N 2JT (GB)

Courier Press, Leamington Spa, England.

## Description

This invention relates to a method of surface hardening cams, and more particularly, of heat treating several cams formed on a cam shaft such as utilized in internal combustion engines.

The heat treatment of metals is an important industrial process which is utilized to impart to the metal desirable properties, such as toughness or hardness. For some applications where steels are used for tools for working metals, it is necessary that the material be hardened to as great a depth as possible so that the tool retains its cutting properties so that it may be ground periodically as it wears. Steel at room temperature consists of two phases:

(1) Ferrite, which is essentially iron that has very small amounts of dissolved carbon and alloying elements, and

(2) Carbides, which are composed mainly of alloying elements and carbon.

To be hardened, the steel must be heated above a certain temperature, where the ferrite transforms to another structure called austenite. The quantity of carbon which the austenite is capable of accepting depends on the temperature, and this quantity decreases as the temperature is lowered. If the austenite is quenched at a sufficiently rapid rate, the carbon is not able to precipitate out of solution and remains trapped in the structure. The trapped carbon produces a super solution in ferrite, which is called martensite. It is the capacity of the steel to keep the carbon in solution and undergo the martensitic transformation which is the important factor in hardening. There is a great variety of carbon tool steels and alloy steels each of which when subjected to the proper heat treatment, results in a product having the desired characteristics for each specific application.

Whereas tools for metalworking require hardness throughout the material, there are many industrial parts which require a hard, wear-resistant surface and a ductile or tough core. Surfaces of such parts are hardened by carburizing, nitriding, cyaniding or carbo-nitriding.

Carburizing requires that the parts be exposed to a carburizing gas at elevated temperatures for periods of about 5 to 72 hours or packed in a carburizing compound for this period. Carbon monoxide or methane is the carrier gas, and carbon dissolves in the austenite and penetrates below the surface by diffusion.

In nitriding, the parts are heated in an ammonia atmosphere at 450 to 540 degrees centigrade (850 to 1000 degrees Fahrenheit) for about 8 to 96 hours. The material is hardened to a depth of 0.025 inches (0.635 mm).

In the carbo-nitriding process, the parts are subjected to a gaseous atmosphere containing hydrocarbons and ammonia at a temperature of 650 to 900 degrees centigrade.

Another process by which steel parts may be hardened is the induction heating process. The parts are held adjacent to, or within, a coil through which alternating current passes. High frequencies are used for small parts or for surface heating and low frequencies are utilized for heating in-depth.

The carburizing, nitriding and cyaniding process are awkward to apply and are time-consuming. Hardening by the use of the induction heating process requires somewhat less time and may be done on a production line basis, but requires the use of specially shaped coils for each application.

Aside from the danger in working with noxious and poisonous gases and liquids and the production of air pollutants formed during the hardening process, all the above processes suffer from the inconvenience resulting from the parts being hardened becoming distorted because they are subjected to high temperatures for long periods of time. If the parts become distorted, it becomes necessary to rework them by remachining them to the required tolerance — a costly procedure made more costly because the parts are then in the hardened state.

A more recent development, disclosed in the EP—A—0001889 is a method of heat treating localised surfaces of a workpiece by causing an electron beam repeatedly to describe a predetermined pattern of points on the work surface such that the localised surface is brought to and maintained at a temperature above the transformation temperature for a predetermined time before the beam is cut-off allowing the surface to cool and harden.

According to the present invention we propose a method of surface hardening the work surfaces of a multiplicity of cams by means of a single concentrated beam of electrons comprising the steps of:

rotating a camshaft upon which the cams are formed or held about its longitudinal axis;

directing and focusing the beam of electrons to a desired spot on the surface of one of the cams;

causing the beam to be displaced to and to dwell in sequence for a presettable period ranging from 2 — 200 micro-seconds at each of a predetermined matrix of spots over a portion of the wear surface of the cam;

causing the beam to be displaced and to dwell in sequence aforesaid on a portion of the wear surface of each of the cams so as to repeat the matrix on a portion of the surface of each of the cams in turn;

repeating without interruption the beam displacement and dwell sequence and matrix over the multiplicity of cams a preset number of times; and

controlling the beam current and beam dwell time on each of the separate cams in accordance with a predetermined program, so that the material on the surface of the areas being treated on each of the cams reaches a temperature above the transformation temperature and close to the melting point for the material, substantially simultaneously on all of the cams.

By this invention the local surfaces of a camshaft can be hardened at extremely high speeds without the disadvantages inherent in traditional methods of heat treating. A high-power density electron beam can be generated by accelerating a beam of electrons by a high-potential, electrostatic field and directed by focusing and deflecting it along two mutually perpendicular axes so that the beam is played upon the work in a desired, two-dimensional pattern as the camshaft is rotated at a predetermined, angular velocity, about its longitudinal axis. In this manner, each of the wear surfaces of all the cams on the camshaft may be heat treated without it being necessary to bring the total mass of the camshaft to the proper heat treating temperature. Because of this, the total energy required by the method of this invention is only a fraction of the energy which must be utilized in traditional processes for heat treating camshafts. With this method, the surfaces on the periphery of each of the cams on the camshaft are rapidly brought to a temperature just below the melting point at the points where the beam is being applied as the camshaft is being rotated. As each incremental surface is rotated away from the beam impingement zone, that surface is self-quenched by the surrounding mass of cold metal in the part. There is no need for a quenching medium, such as a water spray or an oil bath. During the heat treating process, the electron beam is deflected in accordance with a predetermined program of position and dwell time under control of a device which has been programmed to control the deflection coils of the electron gun along two axes so that the beam is stepped instantaneously from one point to the next in a predetermined pattern. The beam remains fixed at each point for a predetermined interval of time so as to produce a pattern of spots of heat over each of the surfaces being heat treated. The concentration of spots may be varied, the beam power may be varied, and/or the dwell time at each point may be varied from area to area being heat treated.

More specifically, in one embodiment the electron beam power density per unit surface of cam is delivered to each cam in sequence in accordance with a predetermined program of power density per unit surface required from spot to spot along the surface of each cam respectively at each of the angular positions taken by each of the cams. Further the electron beam power density per unit surface of cam may be varied in accordance with a preset program. Also, the energy per unit surface of cam may be varied in accordance with a preset program of variation of beam dwell time with respect to the angular position of each cam. In one embodiment, this is achieved by varying the electron beam current and the electron beam dwell time in accordance with a preset program of variations of beam current and beam dwell time with respect to the angular position of each cam.

In another embodiment, the sum of the dwell times at each of the spots the beam dwells on the group of cams being treated is maintained at a fixed value while the beam current delivered at each point varies in accordance with a preset program of electron beam current with respect to the angular position of the camshaft with respect to a given reference.

This invention makes possible the heat treatment of camshafts bearing a multiplicity of cams with the least expenditure of energy and time. It enables a rapid rise in surface temperature over a multiplicity of localized areas of the camshaft.

Another advantage of the present invention, is that the wear surfaces of a multiplicity of cams on a camshaft which has been machined to its final dimensions may be surface hardened with no appreciable distortion resulting in the workpiece due to the hardening process.

Embodiments of the invention will now be described by way of example with reference to the accompanying drawings in which:

Figure 1 is a block diagram showing one embodiment of apparatus for use in the method of this invention;

Figure 2 is a schematic drawing of an electron beam gun and its power supply;

Figure 3 is a front view of a typical camshaft having a multiplicity of cams;

Figure 4 is an end view of the camshaft illustrated in Figure 3;

Figure 5 is an illustration of the shape of a typical cam about its axis of revolution;

Figure 6 is a perspective drawing of a camshaft showing the general motion of the beam as applied to a group of four cams on a single shaft:

Figure 7 shows a pattern of point array for heat treating four cam surfaces simultaneously; and

Figure 8 shows the macro structure of a section of one of the cams shown in Figure 6 after heat treatment by the electron beam.

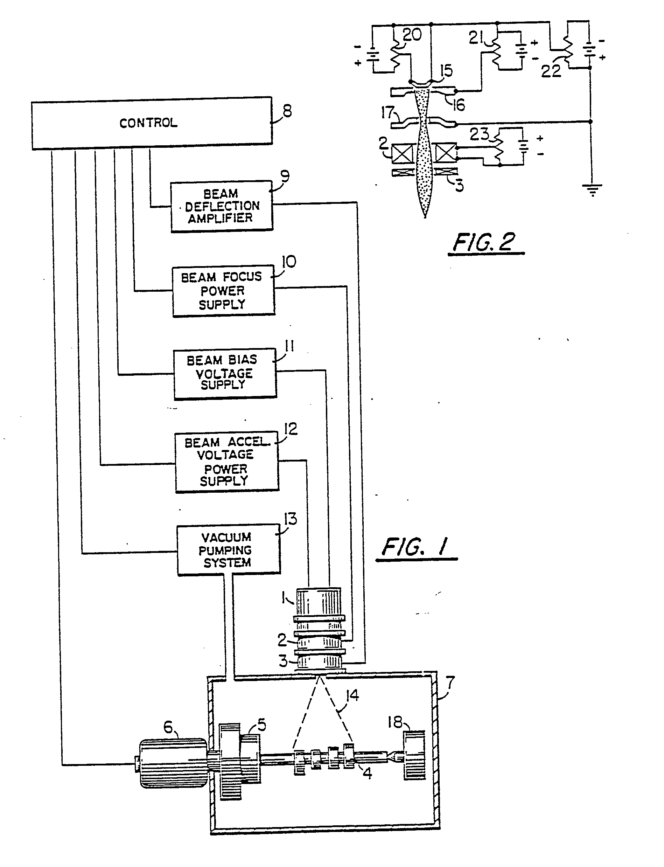

Referring now in Figure 1, which illustrates the complete system for the surface heat treatment by an electron beam of a camshaft bearing a multiplicity of cam lobes, we may note the electron beam gun (1) fitted with a focus coil (2) for focusing the electron beam on the work and deflection coils (3) for deflecting the beam along two mutually perpendicular axes so that the beam may strike each of the cam lobes to be surface heat treated in accordance with a predetermined program applied through the control (8). The camshaft (4) is supported between the trail stock (18) and the head stock (5) within a vacuum chamber (7), which is maintained at a low pressure suitable for the electron beam heat treating process by vacuum pumping system (13). The head stock is driven by the motor (6), whose speed may be regulated and programmed by well-known means provided in control (8). Means are provided in association with the head stock for identifying continuously the angular position of the camshaft with respect to a given reference axis. The overall control, which may be effected by either a computer, a programmable control or a system of logic elements, in conjunction with suitable input and output means, is utilized to control the various parameters of the electron beam system, such as filament current, beam acceleration voltage, focus current, beam deflection, and beam bias (beam current), as well as the overall control and monitoring of the vacuum pumping system and the motor control. In order to heat treat a cam, the operator fastens the camshaft between head stock and tail stock mounted within the vacuum chamber, closes the door of the vacuum chamber, and initiates the functioning of the machine by pressing a start button. The control will then take over the operation, following a preset program which has been established for the operator of the vacuum system to evacuate the chamber to the desired pressure, after which the electron beam gun is automatically energized and the beam controlled so that the desired heat treat pattern of beam displacement and beam dwell time is projected repetitively while the camshaft is rotated at a predetermined angular velocity. The deflection coil assembly (3) is utilized to deflect the electron beam passing through it along two mutually perpendicular axes, and a timing device within the control, acting in conjunction with the deflection means, determines the dwell time of the beam at each predetermined point in the preset pattern of points. For example, the control may be programmed to form a symmetrical 11 × 11 matrix of 121 point locations to which the beam will be directed in sequence for a predetermined period of time to the surface of a portion of the. cam surface to be hardened. The deflection coils are so controlled that this matrix is repeated at a preset rate; for example, 100 matrices (or frames) per second.

Figure 2 illustrates in schematic form the general arrangement of the principal elements of an electron beam gun and its associated electrical supplies. The elements of an electron beam gun system comprise a filament (15), a cathode (16), an anode (17), a focus coil (2), deflection coils (3), and their associated supplies (20), (21), and (23). Filament current supply (2) delivers current to filament (15) and brings the temperature of the filament to the level at which it is in condition to deliver electrons. A high-voltage power supply (22) applies a potential of 60,000 volts to anode (17) with respect to filament (15) to cause the electrons to be accelerated towards the anode and through an aperture in the anode so as to form a beam of electrons moving at a velocity which may approach the speed of light. The cathode (16) and anode (17) are shaped in such a manner as to create an electrostatic field between the anode and the cathode which causes the electron beam to be directed towards a point a short distance outside of the anode. An adjustable DC power supply (21) of approximately 2,000 volts is applied between the filament and the cathode and by the means, the intensity of the electron beam current may be controlled. Increasing the negative potential on the cathode with respect to the filament reduces the electron beam current and vice versa. Beyond the opening in the anode there exists a field free space through which the beam passes through the focus coil (2) where it is focused to a desired spot on a work piece by adjusting the focus current applied to the focus coil by power supply (23). Directly below the focus coil, the deflection coils (3), energized by electrical currents delivered to the coils (3) from the beam deflection amplifiers (9) under control from signals received from a computer or other type of control (8), cause the beam to impinge at a desired point upon the work. The output of all the various current and voltage supplies for the electron beam gun may be controlled and all may be programmed so that these values may be modified and varied during the generation of the points in the matrix or varied for each complete matrix. For example, each successive matrix may be made to differ in beam current during the passage of a series of matrices so as to produce the desired heating effect upon the work piece.

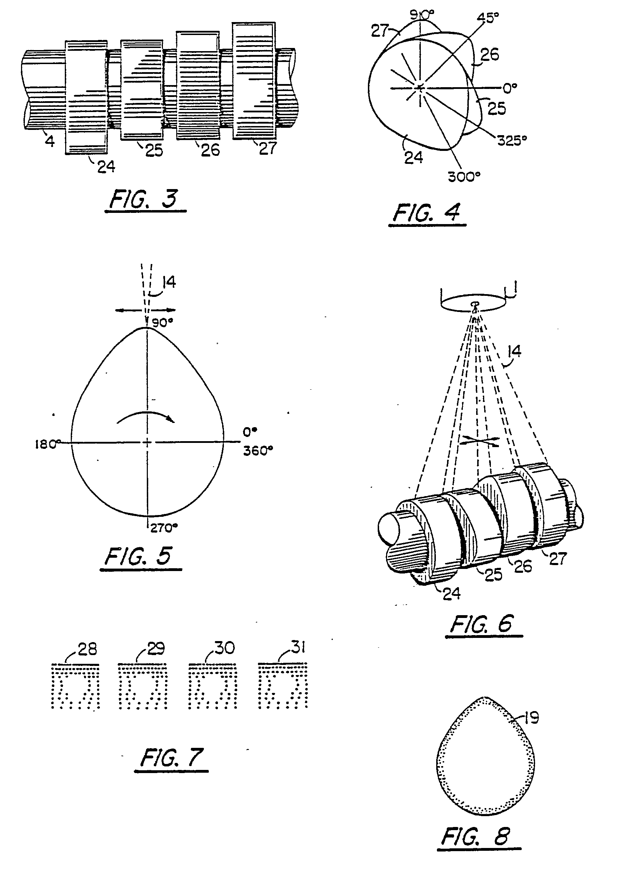

The matrix of Figure 7 represents the points to which the beam is displaced in accordance with a predetermined sequence which is utilized in the heat treatment of four separate cam lobes formed on a single camshaft. This matrix may be displayed upon the screen of a cathode ray oscilloscope for use if setting up and monitoring the heat treat operation. The position of each spot will then be shown on the cathode ray oscilloscope screen, and the brightness of the spots on the screen will indicate the relative length of time the beam remains at any particular spot. Brighter spots indicate longer beam duration.

In the surface heat treatment of a single cam periphery, as illustrated, for example, in Figure 5, it has been found that a uniform heat treatment of the periphery can be obtained by applying the electron beam in a repetitive matrix of a given number of points to a well-defined section of the periphery of the cam if the power density in the beam is continuously adjusted so that the energy applied per unit surface is maintained substantially constant, although the beam strikes the work surface at differing angles as the cam is rotated. For example, with the beam being applied from the top, as shown, it will be normal to the surface of the cam from approximately 180° to slightly more than 360°. From 0° to 90°, the beam will not be normal to the surface, and the portion of the surface which is struck by the matrix will be greater than the surface struck by the matrix as the cam traverses from 180° to 360°. At 90°, the beam will again be normal to the surface, and from 90° to 180°, the area upon which the matrix impinges will again vary and increase in proportion to the reciprocal of the sine of the acute angle between the axis of the beam and the tangent to the surface upon which the beam is impinging. In order to maintain a constant value of energy input per unit surface over the periphery of the cam surface as the cam rotates at a fixed angular velocity, it is necessary to control the average power of a matrix element in proportion to the product of the angular velocity of the cam, the cam radius at the point of impingement of the beam, and the co-secant squared of the angle between the tangent to the cam surface and the cam radius at the point of impingement of the beam.

The present invention is directed to the process whereby a multiplicity of cams on one cam shaft in which the high points on each of the cams are disposed about the camshaft at different angular positions may be heat treated by a single electron beam generated in a single electron beam gun. Heretofore, one could readily concede that this could be done through the use of four electron beam guns, each electron beam gun directing its electron beam to the surface to be heat treated on a separate cam. The present invention utilizes but a single gun in a timesharing process to heat treat a multiplicity of cams.

Figure 3 illustrates a section of a camshaft (4) bearing four lobes (24), (25), (26), and (27). In this particular arrangement, all of the cams are identical in shape, but each is displaced about the shaft (4) in accordance with the required angular displacement needed for a particular application. The angular displacement between the four cam lobes is illustrated in Figure 4. Cam lobe (24) at the front has its highest point at 300°C, cam (25) has its high point at 325°, cam (26) has its high point at 45°, and cam lobe (27) at the rear has its high point at 90°.

Figure 5 illustrates cam (27), for example, rotated about its axis in a clockwise direction while the electron beam (14) is impinging upon its peripheral surface. It has been found that a cam of this shape may be surface hardened to a given depth over its entire wearing surface by the application of an electron beam which is moved rapidly sequentially from spot to spot in accordance with a matrix similar to that shown in matrix (28) of Figure 7 and by causing the beam to be displaced and to dwell in sequence for a presettable period ranging from 2 to 200 microseconds at each of the predetermined spots, and repeating this program of beam motion at rates above 20 frames per second while the cam is rotated at a fixed angular velocity, and the beam current varied in accordance with a predetermined program, related to each angular position of the cam. In the heat treatment of a single cam, the rate of change of electron beam current required lies within the time constant capabilities of the several power supplies utilized in the electron beam generation system. In the heat treatment of a multiplicity of cams whose lobes are angularly displaced from one another, it is necessary to generate a matrix at one energy level on the first cam; for example (24), Figure 6, a second matrix on cam (25) at a different energy level, switch to cam (26) for the third matrix generated at a third level, and then to cam (27) for the fourth matrix at a fourth level, and then repeat the process, developing matrices in sequence on (24), (25), and (27) repeatedly while the cam is rotating at a fixed angular velocity.

Changing the power level (rate of energy input) for each matrix by acting on the beam current control is not feasible inasmuch as the high rates of change of beam current required could not be realized because of the relatively long time constant of the high power supply systems required (in the range of 40 to 100 KW). It was found that the necessary rates of change of energy could be obtained by controlling the dwell time of the beam by the relatively low-power, short-time constant deflection circuits of the electron gun while maintaining the overall time to complete each set of four rasters over the four cams being processed. This concept of changing the dwell time of each spot from cam to cam while varying the current at a relatively slow rate so as to deliver the total energy input required by the group of cams at each angular position while proportioning the dwell time at each cam during a given overall period of time in accordance with the total energy requirement of each, resulted in a surface heat treatment on each of the cams which was essentially the same for all. With the development of means for making sufficiently rapid changes in power level of the electron beam, the proportioning of energy delivered to each cam in sequence may be effected solely by varying the power of the electron beam. A multiplicity of cams may be heat treated by the process of the present invention, which comprises the steps of:

1. Predetermining the program of energy required in the matrix at each angular position of the cam with respect to the beam,

2. Predetermining the sum of the average powers required at each angular position by all of the cams simultaneously,

3. Rotating the camshaft while varying the energy to conform with the total energy required at each of the angular positions taken by the cam shaft; and

4. Varying the dwell time of the matrix developed on each of the cams in sequence, so that each cam receives the required average power input at its periphery in accordance with the predetermined program of power with respect to the angular position of a reference axis on each cam with respect to the beam axis.

To summarize, referring to Figure 6, the raster (28) is played upon cam (24) by deflecting the beam from spot to spot. After the completion of one matrix, the beam is deflected to form matrix (29) on cam (25) and upon its completion, matrix (30) is formed on cam (26) and followed by matrix (31) and cam (27). This sequence of beam translation is repeated until the desired heat treatment is effected. As has been predetermined, cams (24) and (256), whose radius and therefore linear velocity are the same at the indicated points of application of the beam, will require the same beam power at these points, whereas cam (26) and cam (27) will each require more beam power because the peripheral velocity of each at the point of application of the beam is greater. In order to distribute the energy in proportion to that which is required at each position of the cam surfaces, the dwell time of the beam upon each of the several cams is varied during the matrix application to produce the required energy application to that portion of the surface of each of the cams. The control (8), acting upon the beam's amplifiers and power supplies, which produce and direct the beam, causes the delivery of the property energy input at each angular position of each of the cams so as to result in a multiplicity of cams heat treated about each of their peripheries, as illustrated in Figure 8, which in its shaded area (19) shows the uniformity of the heat treatment produced by the process of the present invention.

**Claims**

1. A method of surface hardening the work surfaces of a multiplicity of cams by means of a single concentrated beam of electrons comprising the steps of:
rotating a camshaft upon which the cams are formed or held about its longitudinal axis;
directing and focusing the beam of electrons to a desired spot on the surface of one of the cams;
causing the beam to be displaced to and to dwell in sequence for a presettable period ranging from 2 — 200 microseconds at each of a predetermined matrix of spots over a portion of the wear surface of the cam;
causing the beam to be displaced and to dwell in sequence as aforesaid on a portion of the wear surface of each of the cams so as to repeat the matrix on a portion of the surface of each of the cams in turn;
repeating without interruption the beam displacement and dwell sequence and matrix over the multiplicity of cams a preset number of times; and
controlling the beam current and beam dwell time on each of the separate cams in accordance with a predetermined program, so that the material on the surface of the areas being treated on each of the cams reaches a temperature above the transformation temperature and close to the melting point for the material, substantially simultaneously on all of the cams.

2. A method in accordance with claim 1, in which the electron beam power density per unit surface of cam is delivered to each cam in sequence in accordance with a predetermined program of power density per unit surface required from spot to spot along the surface of each cam respectively at each of the angular positions taken by each of the cams.

3. A method in accordance with claim 2 in which the electron beam power density per unit surface of cam is varied in accordance with a preset program.

4. A method in accordance with claim 2 in which the energy per unit surface of cam is varied in accordance with a preset program of variation of beam dwell time with respect to angular position of each cam.

5. A method in accordance with claim 4 in which the energy per unit surface of cam delivered by the electron beam is varied by varying the electron beam current and the electron beam dwell time in accordance with a preset program of variations of beam current and beam dwell time with respect to the angular position of each cam.

6. A method in accordance with claim 4 in which the sum of the dwell times at each of the spots the beam dwells on the group of cams being treated is maintained at a fixed value while the beam current delivered at each point varies in accordance with a preset program of electron beam current with respect to the angular position of the camshaft with respect to a given reference.

**Patentansprüche**

1. Ein Verfahren zum Oberflächenhärten der Angriffsflächen einer Mehrzahl von Nocken mittels eines einzigen konzentrierten Elektronenstrahles, welches folgende Schritte umfaßt:
Drehen einer Nockenwelle, an der die Nocken ausgeformt oder gelagert sind, um deren Längsachse;
Ausrichten und Fokussieren des Elektronenstrahles auf einen ausgewählten Punkt der Oberfläche eines der Nocken;
Bewirken bezüglich des Strahles, daß dieser in Aufeinanderfolge abgelenkt wird und für eine voreinstellbare Zeitdauer von 2 bis 200 Mikrosekunden auf jedem Punkt einer vorbestimmten Matrix verweilt über einem Teil der Nutzfläche des Nockens;
Bewirken bezüglich des Strahles, daß dieser wie zuvor gesagt in Aufeinanderfolge abgelenkt wird und verweilt auf einem Teil der Nutzfläche jedes der Nocken, sodaß die Matrix auf einem Teil der Oberfläche jedes Nockens der Reihe nach wiederholt wird;
Unterbrechungsloses Wiederholen der Strahlabenkung und Verweilfolge und Matrix über die Mehrzahl der Nocken eine vorgewählte Anzahl von Malen; und
Steuern des Strahlstromes und der Strahlverweilzeit für jeden separaten Nocken in Übereinstimmung mit einem vorbestimmten Programm, sodaß das Material an der Oberfläche der Zonen, die auf jedem Nocken behandelt werden, eine Temperatur über der Umwandlungstemperatur und nahe dem Schmelzpunkt des Materials erreicht, im wesentlichen gleichzeitig für alle Nocken.

2. Verfahren nach Anspruch 1, bei dem die Leistungsdichte des Elektronenstrahls pro Einheit der Nockenfläche an jedem Nocken in Aufeinanderfolge abgegeben wird in Übereinstimmung mit einem vorbestimmten Programm für die Leistungsdichte pro Flächeneinheit, welche von Punkt zu Punkt entlang der Oberfläche jedes Nockens in dieser Reihenfolge erforderlich ist in jeder der Drehlagen, die von jedem der Nocken eingenommen werden.

3. Verfahren nach Anspruch 2, bei dem die Leistungsdichte des Elektronenstrahls pro Einheit der Nockenfläche in Übereinstimmung mit einem voreingestellten Programm variiert wird.

4. Verfahren nach Anspruch 2, bei dem die Energie pro Einheit der Nockenfläche in Übereinstimmung mit einem voreingestellten Programm sur Variation der Strahlverweilzeit in bezug auf die Drehlage jedes Nockens variiert wird.

5. Verfahren nach Anspruch 4, bei dem die vom Elektronenstrahl gelieferte Energie pro Einheit der Nockenfläche dadurch variiert wird, daß der Elektronenstrahlstrom und die Elektronenstrahlverweilzeit in Übereinstimmung mit einem voreingestellten Programm von Variationen des Strahlstromes und er Strahlverweilzeit in bezug auf die Drehlage jedes Nockens variiert werden.

6. Verfahren nach Anspruch 4, bei dem die Summe der Zeiten, die der Strahl auf der Gruppe der behandelten Nocken verweilt, des Verweilens an jedem der Punkte auf einem festen Wert gehalten wird, während der jedem Punkt gelieferte Strahlstrom in Übereinstimmung mit einem voreingestellten Programm für den Elektronenstrahlstrom in bezug auf die Drehlage der Nockenwelle bezüglich einer vorgegebenen Referenz variiert.

**Revendications**

1. Procédé de trempe superficielle des surfaces de travail d'une multiplicité de cames, au moyen d'un faisceau concentré unique d'électrons, procédé caractérisé en ce qu'il comprend les différentes étapes consistant à:

faire tourner un arbre à cames sur lequel les cames sont formées ou fixées, par rotation autour de l'axe longitudinal de cet arbre à cames;

diriger et focaliser le faisceau d'électrons en un point voulu de la surface de l'une des cames;

provoquer le déplacement et l'arrêt séquentiels du faisceau, pendant une période de temps préréglable situé entre 2 et 200 microsecondes, en chacun des points d'une matrice prédéterminée de points situés sur la surface d'usure de la came;

provoquer le déplacement et l'arrêt séquentiels du faisceau, comme décrit ci-dessus, sur une partie de la surface d'usure de chacune des cames, de manière à répéter tour à tour la matrice de points sur une partie de la surface de chacune des cames;

répéter sans interruption, un nombre prédéterminé de fois, la séquence de déplacement et d'arrêt du faisceau, ainsi que la matrice de points, sur la multiplicité des cames; et,

commander le courant du faisceau et le temps d'arrêt du faiseau sur chacune des cames séparées, suivant un programme prédéterminé, de façon que le matériau de la surface des zones traitées sur chacune des cames atteigne une température située au-dessus de la température de transformation et près du point de fusion du matériau, pratiquement simultanément sur toutes les cames.

2. Procédé selon la revendication 1, caractérisé en ce que la densité de puissance du faisceau d'électrons par unité de surface de came, est appliquée séquentiellement à chaque suivant un programme prédéterminé de densité de puissance par unité de surface à appliquer de point le long de la surface de chaque came, respectivement en chacune des positions angulaires prises par chacune des cames.

3. Procédé selon la revendication 2, caractérisé en ce qu'on fait varier, suivant un programme prérégle, la densité de puissance du faisceau d'électrons par unité de surface de came.

4. Procédé selon la revendication 2, caractérisé en ce qu'on fait varier l'énergie par unité de surface de came, suivant un programme prérégle de variation de temps d'arrêt du faisceau par rapport à la position angulaire de chaque came.

5. Procédé selon la revendication 4, caractérisé en ce qu'on fait varier l'énergie par unité de surface de came délivrée par le faisceau d'électrons, en faisant varier le courant du faisceau d'électrons et le temps d'arrêt du faiseau d'électrons suivant un programme préréglé de variations du courant du faisceau et de temps d'arrêt du faisceau par rapport à la position angulaire de chaque came.

6. Procédé selon la revendication 4, caractérisé en ce que la somme des temps d'arrêt, en chacun des points où le faisceau s'arrête sur le groupe de cames en cours de traitement, est maintenue à une valeur fixe, tandis que le courant du faisceau appliqué en chaque point varie suivant un programme préréglé de courant de faisceau d'électron, en fonction de la position angulaire de l'arbre à cames par rapport à une référence donnée.

CONTROL 8

BEAM DEFLECTION AMPLIFIER 9

BEAM FOCUS POWER SUPPLY 10

BEAM BIAS VOLTAGE SUPPLY 11

BEAM ACCEL. VOLTAGE POWER SUPPLY 12

VACUUM PUMPING SYSTEM 13

*FIG. 1*

*FIG. 2*

0 060 257

FIG. 3

FIG. 4

FIG. 5

FIG. 6

FIG. 7

FIG. 8

2